# EUROPEAN PATENT APPLICATION

(11) **EP 4 554 358 A1**
(43) Date of publication of application: **14.05.2025**
(21) Application number: 24192236.8
(22) Date of filing: 01.08.2024
(51) Int. Cl.: H10D 84/01, H10D 30/00, H10D 84/83, H10D 88/00, H10D 30/01, H01L 21/3213, G03F 1/70

(54) **CUT-MASK PATTERNING TO REMOVE CORNER-ROUNDING OF ACTIVE REGIONS OF SEMICONDUCTOR DEVICE**

(30) Priority: 10.11.2023 US 202363548095 P; 18.04.2024 US 202418639141
(71) Applicant: SAMSUNG ELECTRONICS CO., LTD., Yeongtong-gu Suwon-si, Gyeonggi-do 16677 (KR)
(72) Inventor: JUNG, Kangmin, San Jose, CA, 95134 (US); SEO, Kang-ill, San Jose, CA, 95134 (US)
(74) Representative: Kuhnen & Wacker Patent- und Rechtsanwaltsbüro PartG mbB

(57) **Abstract**

Provided is a semiconductor device (40) which includes: a 1^{st} active region (110, 120) extended in a 1^{st} direction (D1) and including: a 1^{st} out-corner edge (R11) at which a width of the 1^{st} active region (110, 120) in a 2^{nd} direction (D2) gradually changes along the 1^{st} direction (D 1); and a 1^{st} in-corner edge (R12) at which the width of the 1^{st} active region (110, 120) less gradually changes along the 1^{st} direction (D1) than at the 1^{st} out-corner edge (R11); and a gate structure (153) extended in the 2^{nd} direction (D2) and overlapping the 1^{st} out-corner edge (R11) in a 3^{rd} direction (D3), wherein the 1^{st} direction (D1) horizontally intersects the 2^{nd} direction (D2), and the 3^{rd} direction (D3) vertically intersects the 1^{st} direction (D1) and the 2^{nd} direction (D2).

## Description

### BACKGROUND

### 1. Field

Apparatuses and methods consistent with the disclosure relate to a semiconductor device in which corner rounding between different-width active regions is removed or reduced.

### 2. Description of Related Art

When a semiconductor cell block for a semiconductor device is formed, an active region of one cell may be formed to have a width different from that of an active region of an adjacent cell to implement different logic circuits based on device performance and device density. For example, while a cell for a high-performance logic circuit may require an active region having a greater width than a cell for a high-efficiency logic circuit, which may instead allow formation of additional elements such as transistor, capacitor, additional contact structures or metal lines, etc. to achieve an increased device density.

However, formation of different-width active regions in a cell block poses technical challenges when a semiconductor device is manufactured based on the cell block. Such challenges may be particularly pronounced in the context of 3D-stacked semiconductor devices, where the need for active regions with non-uniform widths within a cell block significantly increases fabrication challenges.

The 3D-stacked semiconductor device or multi-stack semiconductor device may include one or more 1^{st} transistors formed based on an active region at a 1^{st} stack and one or more 2^{nd} transistors formed based on an active region at a 2^{nd} stack above the 1^{st} stack, where each of the transistors may be a fin field-effect transistor (FinFET), a nanosheet transistor, a forksheet transistor, or any other type of transistor.

Information disclosed in this Background section has already been known to or derived by the inventors before or during the process of achieving the embodiments of the present application, or is technical information acquired in the process of achieving the embodiments. Therefore, it may contain information that does not form the prior art that is already known to the public.

### SUMMARY

According to a first aspect, there is provided a semiconductor device which may include: a 1^{st} active region extended in a 1^{st} direction and including: a 1^{st} out-corner edge at which a width of the 1^{st} active region in a 2^{nd} direction gradually changes along the 1^{st} direction; and a 1^{st} in-corner edge at which the width of the 1^{st} active region less gradually changes along the 1^{st} direction than at the 1^{st} out-corner edge (e.g. a curvature of the 1st in-corner edge may be greater than a curvature of the 1st out-corner edge); and a gate structure extended in the 2^{nd} direction and overlapping the 1^{st} out-corner edge in a 3^{rd} direction, wherein the 1^{st} direction horizontally intersects the 2^{nd} direction, and the 3^{rd} direction vertically intersects the 1^{st} direction and the 2^{nd} direction.

In some embodiments of the semiconductor device, the 1st active region comprises: a 1st source/drain region; a 2nd source/drain region; and a 1st channel structure between the 1st source/drain region and the 2nd source/drain region, and overlapped by the gate structure in the 3rd direction, wherein the 1st out-corner edge overlapped by the gate structure in the 3rd direction is included in the 1st channel structure.

In some embodiments of the semiconductor device, the 1st source/drain region has a 1st width in the 2nd direction, and the 2nd source/drain region has a 2nd width in the 2nd direction, different from the 1st width.

In some embodiments of the semiconductor device, the semiconductor device further comprises: a 2nd active region extended in the 1st direction, above the 1st active region, and comprising: a 2nd out-corner edge at which a width of the 2nd active region in the 2nd direction gradually changes along the 1st direction; and a 2nd in-corner edge at which the width of the 2nd active region less gradually changes along the 1st direction than at the 2nd out-corner edge (e.g. a curvature of the 2nd in-corner edge may be greater than a curvature of the 2nd out-corner edge), wherein the gate structure overlaps the 2nd out-corner edge in the 3rd direction.

In some embodiments of the semiconductor device, the width of the 1st active region is greater than the width of the 2nd active region.

In some embodiments of the semiconductor device, the 2nd out-corner edge is aligned with the 1st out-corner edge in the 2nd direction.

In some embodiments of the semiconductor device, the 2nd in-corner edge is aligned with the 1st in-corner edge in the 2nd direction.

In some embodiments of the semiconductor device, the 1st active region comprises: a 1st source/drain region; a 2nd source/drain region; and a 1st channel structure between the 1st source/drain region and the 2nd source/drain region, and overlapped by the gate structure in the 3rd direction, and the 2^{nd} active region comprises: a 3rd source/drain region above the 1st source/drain region in the 3rd direction; a 4th source/drain region above the 2nd source/drain region in the 3rd direction; and a 2nd channel structure between the 3rd source/drain region and the 4th source/drain region, and overlapped by the gate structure in the 3rd direction, wherein the 1st out-corner edge is included in the 1st channel structure, and wherein the 2nd out-corner edge is included in the 2nd channel structure.

In some embodiments of the semiconductor device, the 1st source/drain region has a 1st width in the 2nd direction, and the 2nd source/drain region has a 2nd width in the 2nd direction, different from the 1st width, and wherein the 3rd source/drain region has a 3rd width in the 2nd direction, and the 4th source/drain region has a 4th width in the 2nd direction, different from the 3rd width.

In some embodiments of the semiconductor device, the 1st active region comprises: a 1st region at a 1st side of the 1st out-corner edge opposite to the 1st in-corner edge, the 1st region having a 1st width in the 2nd direction; and a 2nd region at a 2nd side of the 1st in-corner edge opposite to the 1st out-corner edge, the 2nd region having a 2nd width in the 2nd direction, wherein the 1st width is uniform along the 1st direction, and the 2nd width is uniform in the 1st direction, and wherein the 1st width is different from the 2nd width.

In some embodiments of the semiconductor device, the 1st region is included in a 1st cell of the semiconductor device, and the 2nd region is included in a 2nd cell of the semiconductor device.

In some embodiments of the semiconductor device, the 2nd active region comprises: a 3rd region at the 1st side of the 2nd out-corner edge opposite to the 2nd in-corner edge, the 3rd region having a 3rd width in the 2nd direction; and a 4th region at the 2nd side of the 2nd in-corner edge opposite to the 2nd out-corner edge, the 4th region having a 4th width in the 2nd direction, wherein the 3rd width is uniform along the 1st direction, and the 4th width is uniform along the 1st direction, and wherein the 3rd width is different from the 4th width.

In some embodiments of the semiconductor device, the 1st region and the 3rd region are included in a 1st cell of the semiconductor device, and the 2nd region and the 4th region are included in a 2nd cell of the semiconductor device.

In some embodiments of the semiconductor device, the 1st in-corner edge is not overlapped by the gate structure in the 3rd direction.

According to another aspect, there is provided a semiconductor device which may include: a 1^{st} channel structure; a 1^{st} source/drain region connected to the 1^{st} channel structure; a 2^{nd} source/drain region connected to the 1^{st} channel structure; and a gate structure configured to control current flow between the 1^{st} source/drain region and the 2^{nd} source/drain region through the 1^{st} channel structure, wherein a width of the 1^{st} channel structure in a 2^{nd} direction gradually changes along a 1^{st} direction which intersects the 2^{nd} direction.

In some embodiments of the semiconductor device, the gate structure overlaps the 1st channel structure in a 3rd direction which intersects the 1st direction and the 2nd direction.

In some embodiments of the semiconductor device, a width of the 1st source/drain in a 2nd direction is greater than a width of the 2nd source/drain region in the 2nd direction.

In some embodiments of the semiconductor device, the 1st source/drain region is included in a 1st cell of the semiconductor device, and the 2nd source/drain region is included in a 2nd cell of the semiconductor device.

In some embodiments of the semiconductor device, the semiconductor device further comprises: a 2nd channel structure above the 1st channel structure in the 3rd direction a 3rd source/drain region above the 1st source/drain region in 3rd direction and connected to the 2nd channel structure; a 4th source/drain region above the 2nd source/drain region in the 3rd direction and connected to the 2nd channel structure; and wherein the gate structure is configured to control current flow between the 3rd source/drain region and the 4th source/drain region through the 2nd channel structure, wherein a width of the 2nd channel structure in the 2nd direction gradually varies along the 1st direction.

In some embodiments of the semiconductor device, the gate structure overlaps the 2nd channel structure in the 3rd direction.

In some embodiments of the semiconductor device, a width of the 3rd source/drain in the 2nd direction is greater than a width of the 4th source/drain region in the 2nd direction.

In some embodiments of the semiconductor device, the 3rd source/drain region is included in the 1st cell of the semiconductor device, and the 4th source/drain region is included in the 2nd cell of the semiconductor device.

In some embodiments of the semiconductor device, the width of the 2nd channel structure is smaller than the width of the 1st channel structure.

According to another aspect, there is provided a semiconductor device which may include: a 1^{st} cell comprising a 1^{st} active region; a 2^{nd} cell including a 2^{nd} active region, the 2^{nd} cell being adjacent to the 1^{st} cell in a 1^{st} direction, and the 2^{nd} active region being aligned with the 1^{st} active region in the 1^{st} direction; and a gate structure extended in the 2^{nd} direction across at least one of the 1^{st} active region and the 2^{nd} active region, wherein the 1^{st} active region has a 1^{st} width, and the 2^{nd} active region has a 2^{nd} width smaller than the 1^{st} width in the 2^{nd} direction, wherein the 1^{st} active region comprises a 1^{st} out-corner edge, at which the 1^{st} width gradually changes, the 1^{st} out-corner edge being overlapped by the gate structure in a 3^{rd} direction which intersects the 1^{st} direction and the 2^{nd} direction, and wherein the 2^{nd} active region comprises a 1^{st} in-corner edge at which the 2^{nd} width less gradually changes than at the 1^{st} out-corner edge (e.g. a curvature of the 1st in-corner edge may be greater than a curvature of the 1st out-corner edge).

In some embodiments of the semiconductor device, the 1st in-corner edge is not overlapped by the gate structure in the 3rd direction or aligned with a side surface of the gate structure in the 3rd direction.

In some embodiments of the semiconductor device, the semiconductor device further comprises a 1st channel structure connecting the 1st active region and the 2nd active region, wherein the 1st channel structure is overlapped by the gate structure in the 3rd direction and comprises the 1st out-corner edge.

In some embodiments of the semiconductor device, the 1st cell further comprises a 3rd active region above the 1st active region in the 3rd direction, and the 2nd cell further comprises a 4th active region above the 2nd active region, wherein the 4th active region is aligned with the 3rd active region in the 1st direction, wherein the 3rd active region has a 3rd width, and the 4th active region has a 4th width smaller than the 3rd width in the 2nd direction, wherein the 3rd active region comprises a 2nd out-corner edge, at which the 3rd width gradually changes, the 3rd out-corner edge being overlapped by the gate structure in the 3rd direction, and wherein the 4th active region comprises a 2nd in-corner edge at which the 4th width less gradually changes than at the 2nd out-corner edge (e.g. a curvature of the 2nd in-corner edge may be greater than a curvature of the 2nd out-corner edge.

In some embodiments of the semiconductor device, the 2nd in-corner edge is not overlapped by the gate structure in the 3rd direction or aligned with a side surface of the gate structure in the 3rd direction.

In some embodiments of the semiconductor device, the semiconductor device further comprises a 2nd channel structure connecting the 3rd active region and the 4th active region, wherein the 2nd channel structure is overlapped by the gate structure in the 3rd direction and comprises the 2nd out-corner edge.

In some embodiments of the semiconductor device, the 2nd out-corner edge is aligned with the 1st out-corner edge in the 2nd direction.

In some embodiments of the semiconductor device, the 2nd in-corner edge is aligned with the 1st in-corner edge in the 2nd direction.

According to another aspect, there is provided a method of manufacturing a semiconductor device. The method may include: providing, on a substrate, a 1^{st} active region comprising a 1^{st} region, a 2^{nd} region and a 1^{st} channel region aligned in a 1^{st} direction, wherein the 1^{st} region and the 2^{nd} region have a 1^{st} width and a 2^{nd} width smaller than the 1^{st} width in a 2^{nd} direction, respectively, and the 1^{st} channel region has a 1^{st} out-corner edge, where the 1^{st} width is gradually decreased, and a 1^{st} in-corner edge where the 2^{nd} width is gradually increased; performing cut-mask patterning on the 1^{st} in-corner edge such that a curvature of the 1^{st} in-corner edge is increased; forming a dummy gate structure on the 1sy active region such that the 1^{st} out-corner edge is overlapped by the dummy gate structure in a 3^{rd} direction; and forming 1^{st} source/drain regions based on the channel region, wherein the 1^{st} direction horizontally intersects the 2^{nd} direction, and the 3^{rd} direction vertically intersects the 1^{st} direction and the 2^{nd} direction.

In some embodiments of the method, the method further comprises replacing the dummy gate structure with a gate structure.

In some embodiments of the method, the increased curvature of the 1st in-corner edge is greater than a curvature of the 1st out-corner edge.

In some embodiments of the method, the cut-mask patterning is performed based on a bottom diffusion isolation (BDI) layer formed between the substrate and the 1st active region.

In some embodiments of the method, the method further comprises: providing, on the 1st active region, a 2nd active region comprising a 3rd region, a 4th region and a 2nd channel region aligned in the 1st direction, wherein the 3rd region and the 4th region have a 3rd width and a 4th width smaller than the 3rd width in the 2nd direction, respectively, and the 2nd channel region has a 2nd out-corner edge, where the 3rd width is gradually decreased, and a 2nd in-corner edge where the 4th width is gradually increased, wherein the cut-mask patterning is also performed on the 2nd in-corner edge of the 2nd channel region such that a curvature of the 2nd in-corner edge is increased; wherein the dummy gate structure is formed on the 2nd active region such that the 2nd out-corner edge is also overlapped by the dummy gate structure in the 3rd direction; wherein a 2nd channel structure comprising the 2nd out-corner edge is formed, and wherein 2nd source/drain regions based on the 2nd channel region are formed.

In some embodiments of the method, the cut-masking on the 2nd in-corner edge is performed based on a middle diffusion isolation (MDI) layer formed between the 1st active region and the 2nd active region.

In some embodiments of the method, the 1st out-corner edge is aligned with the 2nd out-corner edge in the 2nd direction.

In some embodiments of the method, the 1st in-corner edge is aligned with the 2nd in-corner edge in the 2nd direction.

In some embodiments of the method, the 1st width is greater than the 3rd width, and the 2nd width is greater than the 4th width.

### BRIEF DESCRIPTION OF DRAWINGS

Example embodiments of the disclosure will be more clearly understood from the following detailed description taken in conjunction with the accompanying drawings.
FIGS. 1A-1C illustrate a 3D-stacked semiconductor device in which active regions having different widths are formed, according to one or more embodiments.
FIG. 2 illustrates a 3D-stacked semiconductor device in which corner rounding is formed in active regions having different widths across a plurality of cells, according to one or more embodiments.
FIGS. 3A-3C illustrate semiconductor devices obtained after respective steps of manufacturing a 3D-stacked semiconductor device in which corner rounding is removed or reduced in active regions having different widths across a plurality of cells, according to one or more embodiments.
FIGS. 4A-4C illustrate semiconductor devices obtained after respective steps of manufacturing a 3D-stacked semiconductor device in which corner rounding is removed or reduced in active regions having different widths across a plurality of cells, according to one or more other embodiments.
FIG. 5 illustrates a flow-chart of manufacturing a 3D-stacked semiconductor device in which corner rounding is removed or reduced in active regions having different widths across a plurality of cells, according to one or more other embodiments.
FIG. 6 is a schematic block diagram illustrating an electronic device including a semiconductor device in which corner rounding is removed or reduced in active regions having different widths across a plurality of cells, according to one or more other embodiments.

### DETAILED DESCRIPTION

The embodiments of the disclosure described herein are example embodiments, and thus, the disclosure is not limited thereto, and may be realized in various other forms. Each of the embodiments provided in the following description is not excluded from being associated with one or more features of another example or another embodiment also provided herein or not provided herein but consistent with the disclosure. For example, even if matters described in a specific example or embodiment are not described in a different example or embodiment thereto, the matters may be understood as being related to or combined with the different example or embodiment, unless otherwise mentioned in descriptions thereof. In addition, it should be understood that all descriptions of principles, aspects, examples, and embodiments of the disclosure are intended to encompass structural and functional equivalents thereof. In addition, these equivalents should be understood as including not only currently well-known equivalents but also equivalents to be developed in the future, that is, all devices invented to perform the same functions regardless of the structures thereof. For example, channel layers, sacrificial layers, and isolation layers described herein may take a different type or form as long as the disclosure can be applied thereto.

It will be understood that when an element, component, layer, pattern, structure, region, or so on (hereinafter collectively "element") of a semiconductor device is referred to as being "over," "above," "on," "below," "under," "beneath," "connected to" or "coupled to" another element the semiconductor device, it can be directly over, above, on, below, under, beneath, connected or coupled to the other element or an intervening element(s) may be present. In contrast, when an element of a semiconductor device is referred to as being "directly over," "directly above," "directly on," "directly below," "directly under," "directly beneath," "directly connected to" or "directly coupled to" another element of the semiconductor device, there are no intervening elements present. Like numerals refer to like elements throughout this disclosure.

Spatially relative terms, such as "over," "above," "on," "upper," "below," "under," "beneath," "lower," "left," "right," "lower-left," "lower-right," "upper-left," "upper-right," "central," "middle," and the like, may be used herein for ease of description to describe one element's relationship to another element(s) as illustrated in the figures. It will be understood that the spatially relative terms are intended to encompass different orientations of a semiconductor device in use or operation in addition to the orientation depicted in the figures. For example, if the semiconductor device in the figures is turned over, an element described as "below" or "beneath" another element would then be oriented "above" the other element. Thus, the term "below" can encompass both an orientation of above and below. The semiconductor device may be otherwise oriented (rotated 90 degrees or at other orientations) and the spatially relative descriptors used herein interpreted accordingly. As another example, when elements referred to as a "left" element and a "right" element" may be a "right" element and a "left" element when a device or structure including these elements are differently oriented. Thus, in the descriptions herebelow, the "left" element and the "right" element may also be referred to as a "1^{st}" element or a "2^{nd}" element, respectively, as long as their structural relationship is clearly understood in the context of the descriptions. Similarly, the terms a "lower" element and an "upper" element may be respectively referred to as a "1^{st}" element and a "2^{nd}" element with necessary descriptions to distinguish the two elements.

It will be understood that, although the terms "1^{st}," "2^{nd}," "3^{rd}," "4^{th}," "5^{th}," "6^{th}," etc. may be used herein to describe various elements, these elements should not be limited by these terms. These terms are only used to distinguish one element from another element. Thus, a 1^{st} element discussed in the description of an embodiment could be termed a 2^{nd} element in a claim without departing from the teachings of the disclosure.

As used herein, expressions such as "at least one of," when preceding a list of elements, modify the entire list of elements and do not modify the individual elements of the list. For example, the expression, "at least one of a, b and c," should be understood as including only a, only b, only c, both a and b, both a and c, both b and c, or all of a, b and c. Herein, when a term "same" is used to compare a dimension of two or more elements, the term may cover a "substantially same" dimension.

It will be also understood that, even if a certain step or operation of manufacturing an apparatus or structure is described later than another step or operation, the step or operation may be performed later than the other step or operation unless the other step or operation is described as being performed after the step or operation.

Many embodiments are described herein with reference to cross-sectional views that are schematic illustrations of the embodiments (and intermediate structures). As such, variations from the shapes of the illustrations as a result, for example, of manufacturing techniques and/or tolerances, are to be expected. Thus, the embodiments should not be construed as limited to the particular shapes of regions illustrated herein but are to include deviations in shapes that result, for example, from manufacturing. Various regions illustrated in the figures are schematic in nature and their shapes are not intended to illustrate the actual shape of a region of a device and are not intended to limit the scope of the disclosure. Further, in the drawings, the sizes and relative sizes of layers and regions may be exaggerated for clarity.

For the sake of brevity, conventional elements, structures or layers of semiconductor devices including a nanosheet transistor and materials forming the same may or may not be described in detail herein. For example, a certain isolation layer or structure of a semiconductor device and materials forming the same may be omitted herein when this layer or structure is not related to the novel features of the embodiments. Also, descriptions of materials forming well-known structural elements of a semiconductor device may be omitted herein when those materials are not relevant to the novel features of the embodiments. Herein, the term "isolation" pertains to electrical insulation or separation between structures, layers, components or regions in a corresponding device or structure.

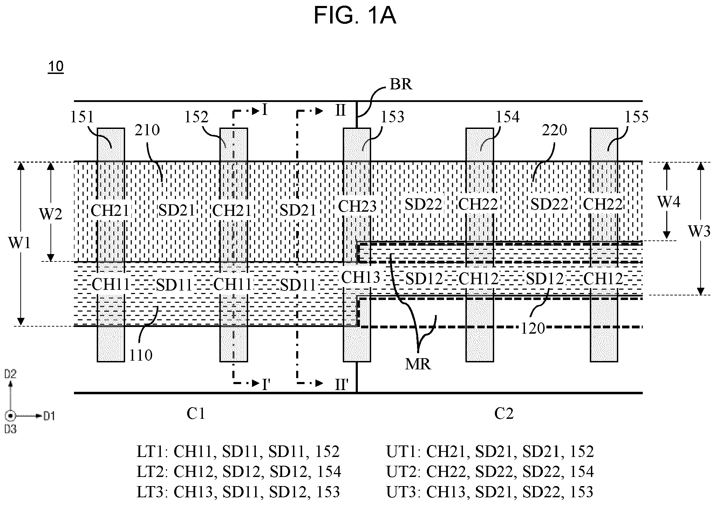

FIGS. 1A-1C illustrate a 3D-stacked semiconductor device in which active regions having different widths are formed, according to one or more embodiments.

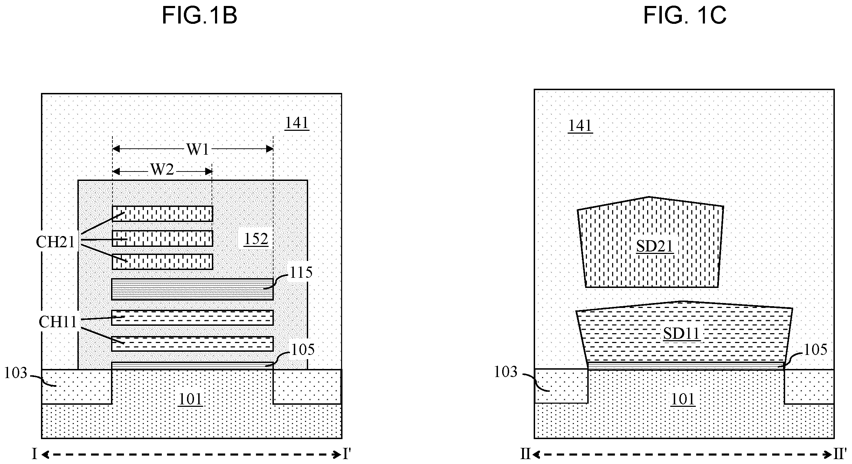

FIG. 1A is a plan view of a cell block 10 of a 3D-stacked semiconductor device in which active regions having different widths are formed, and FIGS. 1B and 1C are cross-section views of the 3D-stacked semiconductor device in the cell block 10 shown in FIG. 1A taken along lines I-I' and II-II', respectively. It is to be understood here that FIG. 1A is provided to show a positional relationship between selected structural elements of the 3D-stacked semiconductor device, and thus, some structural elements such as a substrate 101 and an isolation structure 141 shown in FIGS. 1B and 1C are not shown in FIG. 1A.

As shown in FIG. 1A-1C, a D1 direction is a channel-length direction in which a current flows between two source/drain regions connected to each other through a channel structure, a D2 direction is a channel-width direction or a cell-height direction that intersects the D1 direction, and a D3 direction is a channel-height direction or a vertical direction that intersects the D1 and D2 directions both of which are horizontal directions.

Referring to FIG. 1A, the cell block 10 may include a 1^{st} cell C1 and a 2^{nd} cell C2 arranged in the D1 direction and adjacent to each other. A boundary BR may divide the two cells C1 and C2. The 1^{st} cell C1 may include a 1^{st} lower active region 110 at a lower level (or stack) and a 1^{st} upper active region 210 formed at an upper level (or stack) above the lower level, and the 2^{nd} cell C2 may include a 2^{nd} lower active region 120 at the lower level and a 2^{nd} upper active region 220 formed at the upper level.

The 1^{st} lower active region 110 and the 1^{st} upper active region 210 formed above the 1^{st} lower active region 110 in the D3 direction may be aligned with the 2^{nd} lower active region 120 and the 2^{nd} upper active region 220 formed above the 2^{nd} lower active region 120 in the D1 direction. Thus, the active regions 110. 120, 210 and 220 may all be extended in the D1 direction to form thereon a plurality of channel structure and source/drain regions for respective transistors across the cells C1 and C2 as will be described later.

The active regions 110, 120, 210 and 220 may be epitaxially grown from the substrate 101 (FIGS. 1B and 1C) which may be, for example, a silicon (Si) substrate, not being limited thereto, in a process of manufacturing a 3D-stacked semiconductor device of the cell block 10. Thus, the active regions 110, 120, 210 and 220 may also include silicon or an equivalent material.

In the cells C1 and C2, the lower active region 110 and 120 may differ from the upper active regions 210 and 220 by widths thereof to facilitate formation of contact structures on lower source/drain regions formed on the lower active region 110. The 1^{st} cell C1 may differ from the 2^{nd} cell C2 by widths of the active regions so that these two cells may accommodate logic circuits having different device performances and device densities. Details of the width differences will be described later.

Across the active regions 110, 120, 210 and 220 may be formed a plurality of gate structures 151-155 extended in the D2 direction and arranged in the D1 direction at a predetermined gate pitch or contact poly pitch (CPP). Among the gate structures 151-155, the gate structure 153 may be formed along the boundary BR of the two cells C1 and C2 such that a virtual center line of the gate structure 153 in the D2 direction overlaps the boundary BR. The gate structures 151-155 may each control current flow in the active regions 110 and 120. The gate structures 151-155 may each include a metal or metal compound such as Cu, Al, Ti, Ta, W, Co, TiN, WN, TiAl, TiAlN, TaN, TiC, TaC, TiAlC, TaCN, TaSiN, or a combination thereof, not being limited thereto. The gate structures 151-155 may be formed by replacing corresponding dummy gate structures at the same positions in the cell block 10 in a process of manufacturing a 3D-stacked semiconductor device therein. Thus, herebelow, the gate structure 151-155 may refer to corresponding dummy gate structures in describing various embodiments.

The 1^{st} lower active region 110 may include a 1^{st} lower channel structure CH11 surrounded by each of the gate structures 151 and 152, and the 1^{st} upper active region 210 may include a 1^{st} upper channel structure CH21 surrounded by each of the gate structures 151 and 152. Similarly, the 2^{nd} lower active region 120 may include a 2^{nd} lower channel structure CH12 surrounded by each of the gate structures 153 and 154, and the 2^{nd} upper active region 220 may include a 2^{nd} upper channel structure CH22 surrounded by each of the gate structures 153 and 154. Further, a 3^{rd} lower channel structure CH13 formed based on both the 1^{st} lower active region 110 and the 2^{nd} lower active region 120 may be surrounded by the gate structure 153, and a 3^{rd} upper channel structure CH23 formed based on both the 1^{st} upper active region 210 and the 2^{nd} upper active region 220 may be surrounded by the gate structure 153. Herebelow, these channel structures may also be referred to as channel regions of the respective active regions.

A 1^{st} lower source/drain region SD11 may be formed on each side of the 1^{st} lower channel structure CH11 surrounded by the gate structure 152, and a 1^{st} upper source/drain region SD21 may be formed on each side of the 1^{st} upper channel structure CH21 surrounded by the gate structure 152. Similarly, a 2^{nd} lower source/drain region SD12 may be formed on each side of the 2^{nd} lower channel structure CH12 surrounded by the gate structure 154, and a 2^{nd} upper source/drain region SD22 may be formed on each side of the 2^{nd} upper channel structure CH22 surrounded by the gate structure 154. In contrast, on each side of the 3^{rd} lower channel structure CH13 may be formed the 1^{st} lower source/drain region SD11 and the 2^{nd} lower source/drain region SD12, and on each side of the 3^{rd} upper channel structure CH23 may be formed the 1^{st} upper source/drain region SD21 and the 2^{nd} upper source/drain region SD22.

Based on the above arrangement of the structural elements, three lower transistors and three upper transistors may be formed at the lower level and the upper level, respectively, to form a 3D-stacked semiconductor device in the cell block 10. A 1^{st} lower transistor LT1 may be formed of the 1^{st} lower channel structure CH11, the 1^{st} lower source/drain regions SD11 connected to the 1^{st} lower channel structure CH11, and the gate structure 152 surrounding the 1^{st} lower channel structure CH11. A 2^{nd} lower transistor LT2 may be formed of the 2^{nd} lower channel structure CH12, the 2^{nd} lower source/drain regions SD12 connected to the 2^{nd} lower channel structure CH12, and the gate structure 154 surrounding the 2^{nd} lower channel structure CH12. A 3^{rd} lower transistor LT3 may be formed of the 3^{rd} lower channel structure CH13, the 1^{st} lower source/drain region SD11 and the 2^{nd} lower source/drain region SD12 connected to the 3^{rd} lower channel structure CH13, and the gate structure 153 surrounding the 3^{rd} lower channel structure CH13.

A 1^{st} upper transistor UT1 may be formed of the 1^{st} upper channel structure CH21, the 1^{st} upper source/drain regions SD21 connected to the 1^{st} upper channel structure CH21, and the gate structure 152 surrounding the 1^{st} upper channel structure CH21. A 2^{nd} upper transistor UT2 may be formed of the 2^{nd} upper channel structure CH22, the 2^{nd} upper source/drain regions SD22 connected to the 2^{nd} upper channel structure CH22, and the gate structure 154 surrounding the 2^{nd} upper channel structure CH22. A 3^{rd} upper transistor UT3 may be formed of the 3^{rd} upper channel structure CH23, the 1^{st} upper source/drain region SD21 and the 2^{nd} upper source/drain region SD22 connected to the 3^{rd} upper channel structure CH23, and the gate structure 153 surrounding the 3^{rd} upper channel structure CH23. As shown in FIG. 1B, each of the transistors LT1-LT3 and UT1-UT3 may be a nanosheet transistor.

Each of the source/drain regions SD11, SD12, SD21 and SD22 may be epitaxially grown from at least two channel structures at both sides thereof. For example, the 1^{st} lower source/drain region SD11 may be formed by applying epitaxy on the 1^{st} lower channel structures CH11 surrounded by the gate structures 151 and 152, respectively. As another example, the 2^{nd} upper source/drain region SD22 may be formed by applying epitaxy on the 2^{nd} upper channel structure CH22 surrounded by the gate structure 154 and the 3^{rd} upper channel structure CH23 surrounded by the gate structure 153. Thus, each of the source/drain regions SD11, SD12, SD21 and SD22 may be formed of the same material forming the corresponding channel structures for the epitaxy.

For example, the lower active regions 110 and 120 and the lower channel structures CH11, CH12 and CH13 may be formed of silicon (Si), and the lower source/drain regions SD11 and SD12 may also be formed of silicon. Further, the lower source/drain regions SD11 and SD12 may be implanted or doped with n-type impurities such as phosphorus (P), arsenic (As), antimony (Sb), etc. so that the lower transistors LT1-LT3 may each form an n-type transistor. As another example, the upper active regions 210, 220 and the upper channel structures CH21, CH22 and CH23 may be formed of silicon germanium (SiGe), and the upper source/drain regions SD21 and SD22 may also be formed of silicon germanium. Further, the upper source/drain regions SD21 and SD22 may be implanted or doped with p-type impurities such as boron (B), gallium (Ga), indium (In), etc. so that the upper transistors UT1-UT3 may each form a p-type transistor. However, the disclosure is not limited thereto, and the lower transistors LT1-LT3 may each be formed as either one of the p-type transistor and the n-type transistor, and the upper transistors UT1-UT3 may each be formed as either one of the p-type transistor and the n-type transistor, according to one or more embodiments.

Each of the active regions in the cells C1 and C2 may be formed on the substrate 101, and a bottom dielectric isolation (BDI) layer 105 may be formed on the substrate 101 to isolate the substrate 101 from the gate structures 151-155 and the lower source/drain regions SD11 and SD12 so that current leakage from these structures to the substrate may be prevented. The BDI layer 105 may include silicon nitride (SiN, SiCN, SiBCN, etc.), not being limited thereto. A middle dielectric isolation (MDI) layer 115 may be formed to isolate each of the lower channel structure CH11, CH12 and CH13 from the upper channel structures CH21, CH22 and CH23. The MDI layer may also include silicon nitrides (SiN, SiCN, SiBCN, etc.). At an upper-left corner and an upper-right corner of the substrate 101 may be formed a shallow trench isolation (STI) structure including silicon oxide (e.g., SiO, SiO₂, etc.) that isolate the 3D-stacked semiconductor device from another 3D-stacked semiconductor device or other circuit elements. An isolation structure 141 which may also include silicon oxide (e.g., SiO, SiO₂, etc.) may be formed to surround the gate structures 151-155 and the source/drain regions SD11, SD12, SD21 and SD22 for isolation purposes.

### Width Difference Between Lower Active Region and Upper Active Region

The 1^{st} lower active region 110 may have a width W1 in the D2 direction which is uniform along the D1 direction, and the 1^{st} upper active region 210 may have a width W2 in the D2 direction which is also uniform along the D1 direction. The width W1 may be greater than the width W2. Thus, the 1^{st} lower channel structure CH11 and a left half of the 3^{rd} lower channel structure CH13, each of which is an extension of the 1^{st} lower active region 110 and included in the 1^{st} cell C1, may have the width W1 while the 1^{st} upper channel structure CH21 and a left half of the 3^{rd} upper channel structure CH23, each of which is an extension of the 1^{st} upper active region 210 and included in the 1^{st} cell C1, may each have the width W2. Thus, FIG. 1B shows that the 1^{st} lower channel structure CH11 has the width W1 which is greater than the width W2 of the 1^{st} upper channel structure CH21.

Similarly, the 2^{nd} lower active region 120 may have a width W3 in the D2 direction which is uniform along the D1 direction, and the 2^{nd} upper active region 220 may have a width W4 in the D2 direction which is also uniform along the D1 direction. The width W3 may be greater than the width W4. Thus, the 2^{nd} lower channel structure CH12 and a right half of the 3^{rd} lower channel structure CH13, each of which is an extension of the 2^{nd} lower active region 120 and included in the 2^{nd} cell C2, may each have the width W3 while the 2^{nd} upper channel structure CH22 and right left half of the 3^{rd} upper channel structure CH23, each of which is an extension of the 2^{nd} upper active region 220 and included in the 2^{nd} cell C2, may each have the width W4. Thus, although not shown, the 2^{nd} lower channel structure CH12 has the width W3 which is greater than the width W4 of the 2^{nd} upper channel structure CH22.

As the lower channel structures CH11, CH12 and CH13 have a greater width than the upper channel structures CH21, CH22 and CH23 in the D2 direction as described above, the lower source/drain regions SD11 and SD12 epitaxially grown from the channel structures CH11, CH12 and CH13 may have a greater width than the upper source/drain regions SD21 and SD22 epitaxially grown from the channel structures CH21, CH22 and CH23 in the same D2 direction. FIG. 1C shows that the 1^{st} lower source/drain region SD11 has a greater width than the 1^{st} upper source/drain region SD21 in the D2 direction.

The foregoing width differences may be provided at least to provide a space at a side of each of the upper source/drain region SD21 and SD22 above the lower source/drain regions SD11 and SD 12, respectively, so that a contact structure connecting each of the lower source/drain regions SD11 and SD12 to a metal line in a back-end-of-line (BEOL) layer may be formed on a top surface of each of the lower source/drain regions SD11 and SD12 though the space in a nanometer-scale 3D-stacked semiconductor device.

When the upper channel structures CH21, CH22 and CH23 have a smaller width than the lower channel structures CH11, CH12 and CH13, respectively, the upper channel structures CH21, CH22 and CH23 may each have a greater number of channel layers, which are nanosheet semiconductor layers, than the lower channel structures CH11, CH12 and CH13, respectively. For example, the 1^{st} lower channel structure CH11 may have two nanosheet semiconductor layer while the 1^{st} upper channel structure CH21 may have three nanosheet semiconductor layers. However, these numbers of the semiconductor nanosheet layers are only examples, not limiting the disclosure thereto.

### Width Difference of Active Region Between Cells

As described earlier, the width W1 of the 1^{st} lower active region 110 in the 1^{st} cell C1 may be greater than the width W3 of the 2^{nd} lower active region 120 in the 2^{nd} cell C2. Likewise, the width W2 of the 1^{st} upper active region 210 in the 1^{st} cell C1 may be greater than the width W4 of the 2^{nd} upper active region 220 in the 2^{nd} cell C2, as shown in FIG. 1A.

By differentiating the widths of active regions across the cells C1 and C2, one or more logic circuits formed in the cell C1 may have different device characteristics from one or more logic circuits formed in the cell C2. For example, as the 1^{st} lower transistor LT1 and the 1^{st} upper transistor UT1 in the 1^{st} cell CE1 may have the greater-width channel structures CH11, CH12 and source/drain regions SD11, SD21, a logic circuit or device having high performance and high power consumption may be formed in the 1^{st} cell. In contrast, as the 2^{nd} lower transistor LT2 and the 2^{nd} upper transistor UT2 may have smaller-width channel structures CH12, CH22 and source/drain regions SD12, SD22, a logic circuit or device for high efficiency may be formed in the 2^{nd} cell. For example, in a flip-flop circuit, a clock circuit may be formed in the 1^{st} cell while a master latch or slave latch circuit is formed in the 2^{nd} cell.

Due to the width difference of the active regions across the boundary BR between the cells C1 and C2, each of the 3^{rd} lower channel structure CH13 and the 3^{rd} upper channel structure CH23 may have different widths in the D2 direction along the D1 direction. For example, as shown in FIG. 1A, the left half of the 3^{rd} lower channel structure CH13 may have the width W1 which is greater than the width W3 of the right half of the 2^{nd} lower channel structure CH13, and the left half of the 3^{rd} upper channel structure CH23 may have the width W2 which is greater than the width W4 of the right half of the 2^{nd} upper channel structure CH23. Accordingly, each of the 3^{rd} lower transistor LT3 including the 3^{rd} lower channel structure CH13 and the 3^{rd} upper transistor UT3 including the 3^{rd} upper channel structure CH23 may each have different-width source/drain regions.

Thus, either of these two transistors LT3 and UT3 or a combination of these two transistors LT3 and UT3 may form a transistor structure that may be tailored to various different purposes. For example, a logic circuit that requires a large amount of a source current to flow to a drain region with less resistance and at a lower gate threshold voltage may include the 3^{rd} lower transistor LT3 or the 3^{rd} upper transistor UT3.

In the meantime, the 2^{nd} lower active region 120 and the 2^{nd} upper active region 220 may be formed by pattering an initial lower active region having the width W1 and an initial upper active region having the width W2 such that the widths W1 and W2 are reduced to the widths W3 and W4, respectively, in an area corresponding to the second cell C2 while the widths W1 and W2 are maintained in an area corresponding to the 1^{st} cell C1.

This patterning operation may be performed through photolithography, masking, etching operations on the initial lower active region and the initial upper active region, respectively. For example, one or more hard mask patterns may be formed on top surfaces of the initial lower active region and the initial upper active region at one or more positions to expose regions MR (shown in FIG. 1A) on the top surfaces, and dry or wet etching may be performed based on the hard mask patterns to remove the initial 1^{st} lower active region and the 1^{st} upper active region in the regions MR to form the 2^{nd} lower active region 120 and the 2^{nd} upper active region 220 in addition to the 1^{st} lower active region 110 and the 1^{st} upper active region 210.

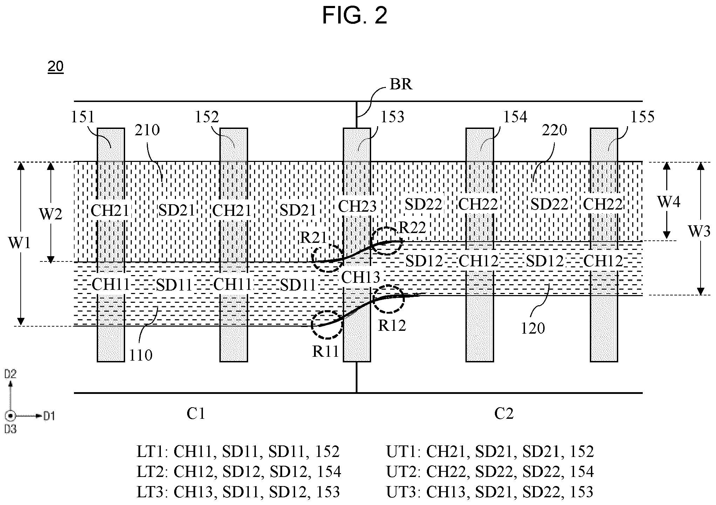

However, because of process variation and limitation of the photolithography, masking, and etching operations, it may be very difficult to form the 1^{st} lower active region 110 and the 1^{st} upper active region 210 having the respectively uniform widths W1 and W2 along a forward (rightward) D1 direction to the cell boundary BR and to form the 2^{nd} lower active region 120 and the 2^{nd} upper active region 220 having the respectively uniform widths W3 and W4 along a backward (leftward) D1 direction to the boundary BR, as shown in FIG. 1A. Instead, the width reduction at the cell boundary BR may take a tapering form as shown in FIG. 2.

FIG. 2 illustrates a 3D-stacked semiconductor device in which corner rounding is formed in active regions having different widths across a plurality of cells, according to one or more embodiments.

Referring to FIG. 2 which is a plan view corresponding to FIG. 1A, a cell block 20 of a 3D-stacked semiconductor device may include the same cells C1 and C2 and the structural elements included in the cell block 10 of FIG. 1A. Thus, duplicate descriptions thereof may be omitted, and instead, different aspects of the cell block 20 may be described herebelow using the same reference numerals as necessary.

Unlike in the cell block 10, the respective widths W1 and W2 of the 1^{st} lower active regions 110 and the 1^{st} upper active region 210 in the 1^{st} cell C1 of the cell block 20 may not be uniform along the forward (rightward) D1 direction to the cell boundary BR, and also, the respective widths W3 and W4 of the 2^{nd} lower active region 120 and the 2^{nd} upper active region 220 may not be uniform along the backward (leftward) D1 direction to the cell boundary BR. Instead, the respective widths W1 and W2 of the 1^{st} lower active region 110 and the 1^{st} upper active region 210 may begin to gradually decrease from positions near the cell boundary BR outside the gate structure 153 in the cell C1 to the cell boundary BR, and the widths W3 and W4 of the 2^{nd} lower active region 110 and the 2^{nd} upper active region 220 may begin to gradually increase from positions near the cell boundary BR outside the gate structure 153 in the cell C2 to the cell boundary BR.

Thus, as shown in FIG. 2, the 1^{st} lower active region 110 may have out-corner rounding at around an out-corner edge R11 outside the gate structure 153 where the width W1 begins to gradually decrease and the 1^{st} upper active region 210 may have out-corner rounding at around an out-corner edge R21 outside the gate structure 153 where the width W2 begins to gradually decrease. Similarly, the 2^{nd} lower active region 120 may have in-corner rounding at around an in-corner edge R12 outside the gate structure 153 where the width W2 begins to gradually increase and the 2^{nd} upper active region 220 may have in-corner rounding at around an in-corner edge R22 outside the gate structure 153 where the width W4 begins to gradually increase. Because of the corner rounding, each of the corner edges R11, R12, R21 and R22 may have respective curvatures. Further, the channel structures CH13 and CH23 have gradual width change along the D1 direction below the gate structure 153 in the D3 direction. Moreover, the corner rounding outside the gate structure 153 generates active region deficiency at around the out-corner edges R11 and R21 and active region excess at around the in-corner edges R12 and R22.

The corner rounding at around the corner edges R11, R21, R12 and R22 of the active regions 110, 120, 210 and 220 and the gradual width change may be caused by process variation and limitation of the photolithography, masking, and etching operations to form the two lower active regions 110 and 120 from an initial lower active region and to form the two upper active regions 210 and 220 from an initial upper active region. This corner rounding may also result in additional process variation in the subsequent operations including formation of the source/drain regions SD11, SD12, SD21 and SD22 by epitaxially growing the 3^{rd} channel structures CH12 and CH23 surrounded by a dummy gate structure (to be replaced by the gate structure 153). For example, after the source/drain regions SD12 and SD12 are grown from the channel structures CH13 and CH23, and the dummy gate structure is replaced by the gate structure 153, a short-circuit may occur or increase between the gate structure 153 and the source/drain regions SD12 and SD22 formed based on the 3^{rd} lower channel CH13 and the 3^{rd} upper channel structure CH 23 because of the active region excess at the in-corner edges R12 and R22. Further, the active region deficiency at the out-corner edges R11 and R21 may cause insufficient formation of the source/drain regions SD11 and SD21.

Provided below are embodiments of a method of removing or reducing the corner rounding regions in the active regions and a 3D-stacked semiconductor device manufactured based on the method.

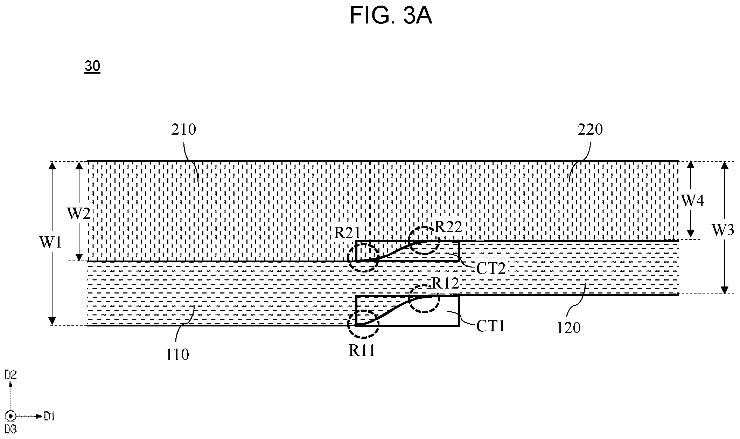

FIGS. 3A-3C illustrate semiconductor devices obtained after respective steps of manufacturing a 3D-stacked semiconductor device in which corner rounding is removed or reduced in active regions having different widths across a plurality of cells, according to one or more embodiments. Since the 3D-stacked semiconductor device described herebelow corresponds to the 3D-stacked semiconductor device shown in FIGS. 1A and 2, the same reference numerals may be used in the descriptions.

Referring to FIG. 3A, an initial lower active region having a width W1 and an initial upper active region having a width W2 and formed above the initial lower active region may be patterned so that the initial active regions may be divided into a 1^{st} lower active region 110 having the with W1, a 1^{st} upper active region 210 having the width W2, a 2^{nd} lower active region 120 having a width W3, and a 2^{nd} upper active region 220 having a width W4 are formed. The patterning operation in this step may be performed through, for example, photolithography, masking and etching on the initial lower active region and the initial upper active region. The width W1 is greater than the width W2, and the width W3 is greater than the width W4.

However, because of patterning variation and limitation, the width W1 of the initial lower active region and the width W2 of the initial upper active region may be gradually decreased or tapered in the forward D1 direction, and thus, the 1^{st} lower active region 110 and the 1^{st} upper active region 210 may have out-corner rounding at around out-corner edges R11 and R21, and the 2^{nd} lower active region 120 and the 2^{nd} upper active region 220 may have in-corner rounding at around in-corner edges R12 and R22, respectively, as shown in FIG. 3A. The out-corner edges R11 and R21 may be aligned with each other in the D2 direction, and the in-corner edges R12 and R22 may also be aligned with each other in the D2 direction.

A cut-mask patterning may be performed on a 1^{st} cut-mask area CT1 and a 2^{nd} cut-mask area CT2 to remove the out-corner rounding and the in-corner rounding. The cut-mask patterning may be performed through additional photolithography, masking and etching operations by forming one or more hard mask patterns at positions on a top surface of each of the initial lower active region and the initial upper active region divided into the four active regions 110, 120, 210 and 220. The hard mask patterns may expose the cut-mask areas CT1 and CT2, based on which dry or wet etching may be performed.

In the meantime, the initial lower active region may have been formed from a substrate 101 with a BDI layer 105 therebetween, and the initial upper active region may have been formed above the initial lower active region with an MDI layer 115 therebetween (see FIGS. 1B and 1C). Thus, the above-described pattering and cut-mask patterning may be performed based on the BDI layer and the MDI layer as etch stop layers.

The initial lower active region and the initial upper active region may both include a plurality of nanosheet semiconductor layers epitaxially grown one by one from the substrate 101. The nanosheet semiconductor layers may include sacrificial layers and channel layers alternatingly stacked on the substrate 101. In later steps, the sacrificial layers may be replaced with a material forming a gate structure and a material forming the BDI layer 105 and the MDI layer 115, and the channel layers may form a plurality of channel structures.

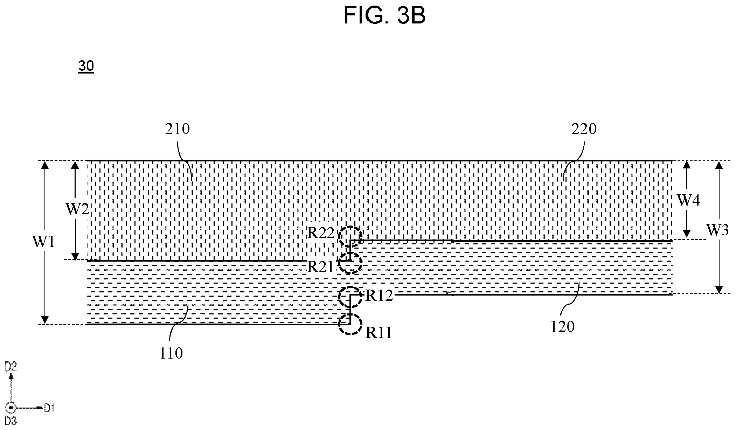

Referring to FIG. 3B, due to the cut-mask patterning in the previous step, the 1^{st} lower initial lower active region 110 and the 1^{st} upper active region 210 may be formed to have uniform widths W1 and W2 along the D1 direction, and the 2^{nd} lower active region 120 and the 2^{nd} upper active region 220 may be formed to have uniform widths W3 and W4 along the D1 direction.

However, the cut-mask patterning performed in the previous step may also leave minimal out-corner rounding and in-corner rounding at around out-corner edges R11, R21 and in-corner edges R12, R22. Still, however, due to the cut-mask patterning, curvatures of the out-corner edges R11, R21 and the in-corner edges R12, R22 in this step (FIG. 3B) may be greater than curvatures at the out-corner edges R11, R21 and the in-corner edges R12, R22 in the previous step (FIG. 3A). It is to be understood that the higher is the curvature of an active region, the sharper is the bending of the active region. Thus, the width W1 of the initial lower active region and the width W2 of the initial upper active region may less gradually change at the corner edges R11, R12, R21 and R22 in this step (FIG. 3B) than at the corner edges R11, R12, R21 and R22 in the previous step (FIG. 3A). A less gradual change of the width at a first corner edge compared to the change of the width at a second corner edge may mean that the first corner edge has a greater curvature than the second corner edge.

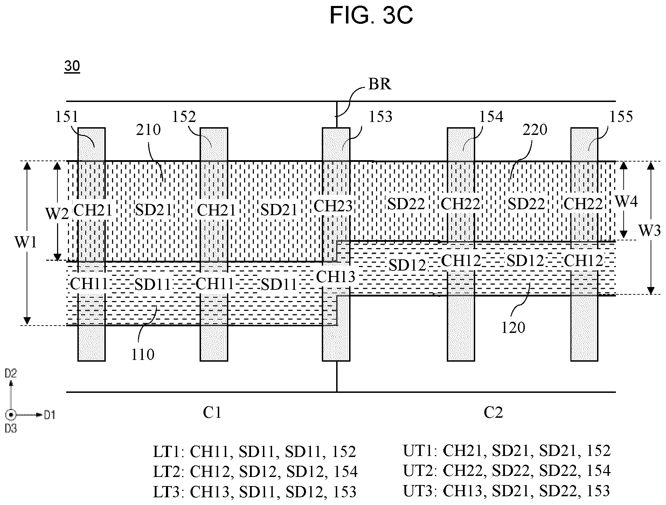

Referring to FIG. 3C, a 1^{st} cell C1 and a 2^{nd} cell C2 may be formed, in which channel structures CH11, CH12, CH13, CH21, CH22 and CH23, source/drain regions SD11, SD12, SD21 and SD22, and gate structures 151-155 are formed based on the active regions 110, 120, 210 and 220 having different widths.

The channel structures CH11, CH12, CH13, CH21, CH22 and CH23 may be first formed by forming dummy gate structure at positions of the gate structures 151-155 and etching the active regions 110, 120, 210 and 220 at positions where the source/drain regions SD11, SD12, SD21 and SD22 are to be formed. At this time, a dummy gate structure corresponding to the gate structure 153 may be formed to overlap a boundary BR between the 1^{st} lower active region 110 and the 2^{nd} lower active region 120. This boundary BR also divides the 1^{st} upper active region 210 and the 2^{nd} upper active region 220. Based on this boundary BR, a 1^{st} cell C1 and a 2^{nd} cell C2 having different widths of active region are formed.

In the meantime, the channel structures CH13 and CH23 may be formed to include the corner edges R11, R12, R21 and R22, and the gate structure 153 replacing the dummy gate structure may overlap the corner edges R11, R12, R21 and R22 in the D3 direction.

Next, the source/drain regions may be epitaxially grown from the channel structures surrounded by the dummy gate structures, and the dummy gate structures and the sacrificial layers including in the active regions 110, 120, 210 and 220 may be replaced with the gate structure 151-155, to form respective lower transistors LT1-LT3 and upper transistors UT1-UT3 for the 3D-stacked semiconductor device 30.

Herebelow, another method of removing or reducing the corner rounding regions in active regions and a 3D-stacked semiconductor device manufactured based on this method are provided.

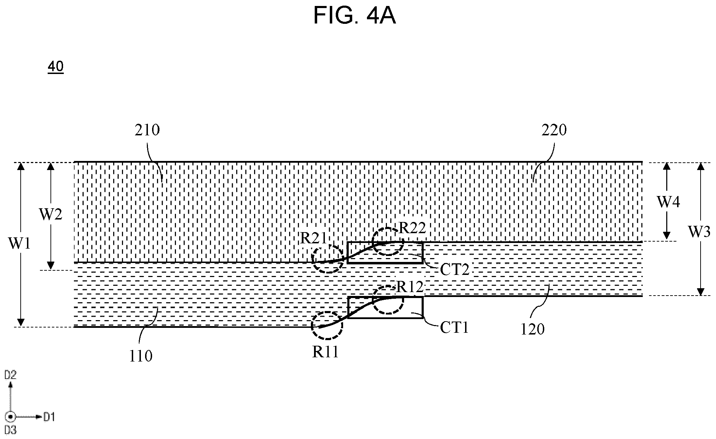

FIGS. 4A-4C illustrate semiconductor devices obtained after respective steps of manufacturing a 3D-stacked semiconductor device in which corner rounding is removed or reduced in active regions having different widths across a plurality of cells, according to one or more other embodiments. Since the 3D-stacked semiconductor device described herebelow corresponds to the 3D-stacked semiconductor device shown in FIGS. 1A and 2, the same reference numerals may be used in the descriptions.

Referring to FIG. 4A, an initial lower active region having a width W1 and an initial upper active region having a width W2 and formed above the initial lower active region may be patterned so that the initial active regions are divided into a 1^{st} lower active region 110 having the with W1, a 1^{st} upper active region 210 having the width W2, a 2^{nd} lower active region 120 having a width W3, and a 2^{nd} upper active region 220 having a width W4 are formed. The patterning operation in this step may be performed through, for example, photolithography, masking and etching on the initial lower active region and the initial upper active region. The width W1 is greater than the width W2, and the width W3 is greater than the width W4.

However, because of patterning variation and limitation, the width W1 of the initial lower active region and the width W2 of the initial upper active region may be gradually reduced or tapered in the forward D1 direction, and thus, the 1^{st} lower active region 110 and the 1^{st} upper active region 210 may have out-corner rounding at around out-corner edges R11 and R21, and the 2^{nd} lower active region 120 and the 2^{nd} upper active region 220 may have in-corner rounding at around in-corner edges R12 and R22, respectively, as shown in FIG. 4A. The out-corner edges R11 and R21 may be aligned with each other in the D2 direction, and the in-corner edges R12 and R22 may also be aligned with each other in the D2 direction.

A cut-mask patterning may be performed on a 1^{st} cut-mask area CT1 and a 2^{nd} cut-mask area CT2 to remove the in-corner rounding. The cut-mask patterning may be performed through additional photolithography, masking and etching operations by forming one or more hard mask patterns at positions on a top surface of each of the initial lower active region and the initial upper active region divided into the four active regions 110, 120, 210 and 220. The hard mask patterns may expose the cut-mask areas CT1 and CT2, based on which dry or wet etching may be performed.

In the meantime, the initial lower active region may have been formed from a substrate 101 with a BDI layer 105 therebetween, and the initial upper active region may have been formed above the initial lower active region with an MDI layer 115 therebetween (see FIGS. 1B and 1C). Thus, the above-described pattering and cut-mask patterning may be performed based on the BDI layer and the MDI layer as etch stop layers.

The initial lower active region and the initial upper active region may both include a plurality of nanosheet semiconductor layers epitaxially grown one by one from the substrate 101. The nanosheet semiconductor layers may include sacrificial layers and channel layers alternatingly stacked on the substrate 101. In later steps, the sacrificial layers may be replaced with a material forming a gate structure and a material forming the BDI layer 105 and the MDI layer 115, and the channel layers may form a plurality of channel structures.

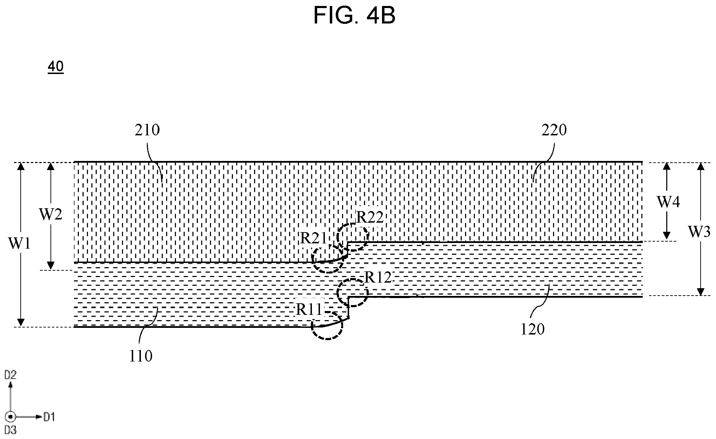

Referring to FIG. 4B, due to the cut-mask patterning in the previous step, the 2^{nd} lower initial lower active region 120 and the 2^{nd} upper active region 210 may be formed to have uniform widths W3 and W4 along the backward D1 direction to in-corner edges R12 and R22.

However, out-corner rounding at around the out-corner edges R11 and R21 may still remain on the 1^{st} lower active region 110 and the 1^{st} upper active region 210, respectively. Further, the cut-mask patterning performed in the previous step may also leave minimal in-corner rounding at around the in-corner edges R12 and R22. Still, however, due to the cut-mask patterning, curvatures of the in-corner edges R12 and R22, where the widths W3 and W4 begin to increase, in this step (FIG. 4B) may be greater than curvatures of the in-corner edges R12 and R22 in the previous step (FIG. 4A) as well as curvatures of the out-corner edges R11 and R21 at around which the widths W1 and W2 gradually decreases. Thus, the width W1 of the initial lower active region and the width W2 of the initial upper active region may still gradually change at the out-corner edges R11 and R21 and less gradually change at the in-corner edges R12 and R22 than at the out-corner edges R11 and R21 in this step (FIG. 4B) as well as at the in-corner edges R12 and R22 in the previous step (FIG. 4A).

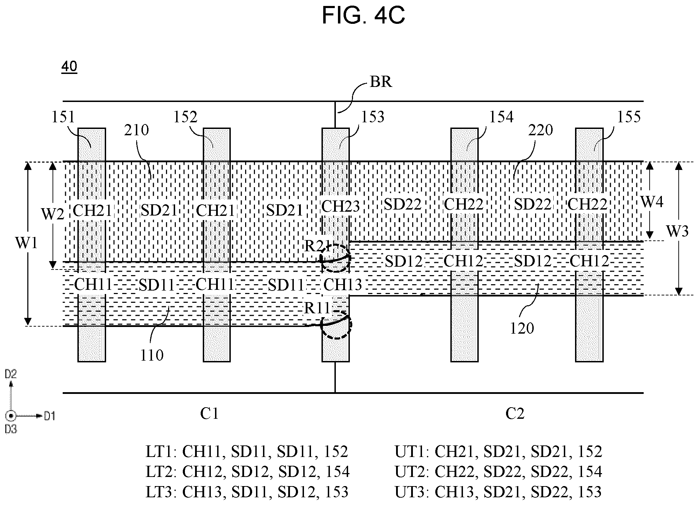

Referring to FIG. 4C, a 1^{st} cell C1 and a 2^{nd} cell C2 may be formed, in which channel structures CH11, CH12, CH13, CH21, CH22 and CH23, source/drain regions SD11, SD12, SD21 and SD22, and gate structures 151-155 are formed based on the active regions 110, 120, 210 and 220 having different widths.

The channel structures CH11, CH12, CH13, CH21, CH22 and CH23 may be first formed after forming dummy gate structure at positions of the gate structures 151-155 and etching the active regions 110, 120, 210 and 220 at positions where the source/drain regions SD11, SD12, SD21 and SD22 are to be formed. At this time, a dummy gate structure corresponding to the gate structure 153 may be formed to overlap the out-corner edges R11 and R21 in the D3 direction. Thus, a boundary BR between the 1^{st} lower active region 110 and the 2^{nd} lower active region 120 may overlap the out-corner edges R11 and R21 in the D3 direction. This boundary BR also divides the 1^{st} upper active region 210 and the 2^{nd} upper active region 220. Based on this boundary BR, a 1^{st} cell C1 and a 2^{nd} cell C2 having different widths of active region may be formed. However, this dummy gate structure overlapping the out-corner edges R11 and R21 may not overlap the in-corner edges R12 and R22 or a side surface of the dummy gate structure may overlap the in-corner edges R12 and R22 in the D3 direction.

Thus, the channel structures CH13 and CH23 may be formed to include the out-corner edges R11 and R21, but not including the in-corner edges R12 and R22. When the channel structures CH13 and CH23 include the out-corner edges R11 and R12, the channel structures CH13 and CH23 may each have a width gradually changing below the dummy gate structure.

Next, the source/drain regions may be epitaxially grown from the channel structures surrounded by the dummy gate structures, and the dummy gate structures and the sacrificial layers including in the active regions 110, 120, 210 and 220 may be replaced with the gate structure 151-155, to form respective lower transistors LT1-LT3 and upper transistors UT1-UT3 for a 3D-stacked semiconductor device 40.

By the above-described methods, corner-rounding at the corner edges may be removed, and thus, active region deficiency and excess may also be removed. Thus, a 3D-stacked semiconductor device in which active regions have different widths across a plurality of cells may be formed without or with a reduced short-circuit risk between a gate structure and the corner-rounded source/drain regions and without or with a reduced risk of insufficient formation of source/drain regions.

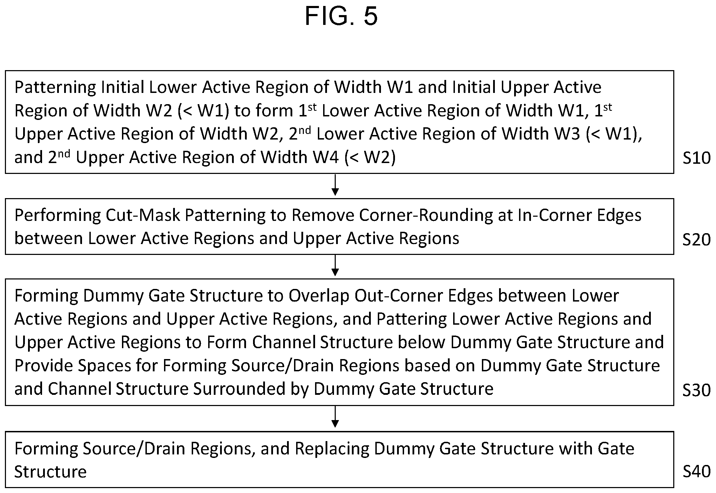

FIG. 5 illustrates a flow-chart of manufacturing a 3D-stacked semiconductor device in which corner rounding is removed or reduced in active regions having different widths across a plurality of cells, according to one or more other embodiments. The description of the flow-chart may be provided using the same reference numbers used to describe the above embodiments.

In step S10, an initial lower active region having a width W1 and an initial upper active region having a width W2 smaller than the width W1 may be patterned to form a 1^{st} lower active region 110 having the with W1, a 1^{st} upper active region 210 having the width W2, a 2^{nd} lower active region 120 having a width W3, and a 2^{nd} upper active region 220 having a width W4 smaller than the width W3.

The patterning operation may be performed by photolithography, masking and etching the initial active regions based on a BDI layer 105 formed between a substrate and the initial lower active region, and an MDI layer 115 formed between the initial lower active region and the initial upper active region.

However, as the patterning operation has process variation and limitation that prevents precise patterning of the initial active regions to have the widths W1, W2, W3 and W3 uniform along the D1 direction from a boundary BR of the divided active regions 110, 120, 210 and 220, corner rounding may be formed at an in-corner edge R12 and an out-corner edge R11 between the lower active regions 110 and 120, and an in-corner edge R22 and an out-corner edge R21 between the upper active regions 210 and 220.

In step S20, a cut-mask patterning may be performed to remove the corner-rounding at the in-corner edge R12 between the lower active regions 110 and 120 and the in-corner edge R22 between the upper active regions 210 and 220.

The cut-mask pattering in this step may also be performed through photolithography, masking and etching operations which still have process variation and limitation. However, due to this cut-mask patterning, the corner rounding may be at least reduced so that curvatures of the in-corner edges R12 and R22 increases. Still, however, the corner rounding at the out-corner edges R11 and R21 may remain.

In step S30, a dummy gate structure (to be replaced by a gate structure 153) may be formed to overlap the out-corner edges R11 and R21, and the lower active regions 110, 120 and the upper active regions 210 and 220 may be patterned to form a channel structure below the dummy gate structure and provide spaces for forming source/drain regions based on the dummy gate structure and the channel structure surrounded by the dummy gate structure.

When the out-corner edges R11 and R21 are overlapped by the dummy gate structure, the out-corner edges R11 and R21 may be surrounded by the dummy gate structure to remove the corner rounding at the out-corner edges R11 and R21, thereby removing or reducing active region deficiency outside the dummy gate structure. Thus, insufficient formation of the source/drain regions SD11 and SD21 in a next step may be avoided. Further, since the corner rounding at the in-corner edges R12 and R22 may have also been removed or reduced by the cut-mask patterning, the source/drain regions SD12 and SD22 may be formed in the next step without or with a reduced risk of a short-circuit with the gate structure 153 that will replace the dummy gate structure.

Further, the 1^{st} lower active region 110 and the 1^{st} upper active region 210 at one side of the dummy gate structure and the 2^{nd} lower active region 120 and the 2^{nd} upper active regions 220 at the other sides of the dummy gate structure may be patterned based on the dummy gate structure to form channel structure CH13 and CH23 below the dummy gate structure and spaces for formation of source/drain regions at the sides of the dummy gate structure. At this time, the channel structures CH13 and CH23 may include the out-corner edges R11 and R21 overlapped by the dummy gate structure.

In step S40, source/drain regions SD11, SD12, SD21 and SD22 may be formed based on the channel structures CH13 and CH23, and the dummy gate structure may be replaced by a gate structure 153.

As described in the previous step, the source/drain regions SD11, SD12, SD21 and SD22 may be formed based on the channel structures CH13 and CH23 including the out-corner edges R11 and R21 overlapped by the dummy gate structure without or with a reduced risk of forming insufficient source/drain regions SD 11 and SD21 and a short circuit between the gate structure 153 and at least one of source/drain regions SD12 and SD22.

In the above embodiments, corner edges where widths of active regions gradually change or less gradually change are indicated as being formed at channel structures below a gate structure and overlapping a boundary between two adjacent cells. However, the disclosure is not limited thereto. According to one or more embodiments, active regions may be formed to have width changes inside a cell for a 3D-stacked semiconductor device, not at channel structures, not below a gate structure, or not overlapping a boundary between two adjacent cells.

In the above embodiments, both of a lower active region and an upper active region have gradual and less gradual width changes. However, the disclosure is not limited thereto. According to one or more embodiments, only one of a lower active region and an upper active region may have a gradual and less gradual width change while the other has a uniform width along the D1 direction.

In the above embodiments, a lower active region and an upper active region have difference widths to facilitate formation of a contact structure on a top surface of a source/drain region. However, the disclosure is not limited thereto, and the embodiments may also apply to a 3D-stacked semiconductor device in which a lower active region and an upper active region have a same width.

In the above embodiments, the semiconductor device in which active regions have different widths as described above is described as a 3D-stacked semiconductor device. However, the disclosure is not limited thereto, and the embodiments may also apply to a single-stack 3D-stacked semiconductor device.

In the above embodiments, the 3D-stacked semiconductor devices 10, 20, 30 and 40 are described as being formed of a lower nanosheet transistor of n-type and an upper nanosheet transistor of p-type. However, these 3D-stacked semiconductor devices may be formed of a transistor of different type and/or different polarity at a lower level and/or an upper level, according to one or more embodiments.

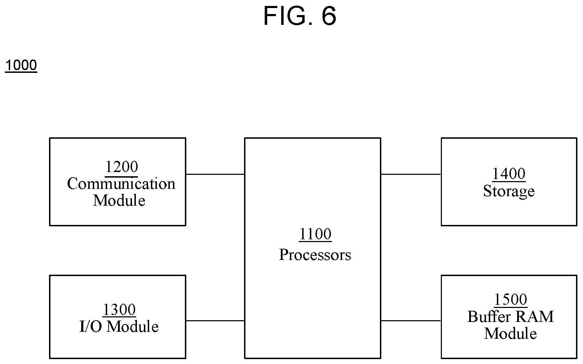

FIG. 6 is a schematic block diagram illustrating an electronic device including a semiconductor device in which corner rounding is removed or reduced in active regions having different widths across a plurality of cells, according to one or more other embodiments. This semiconductor device may be one of the 3D-stacked semiconductor devices 30 and 40 shown in FIGS. 3C and 4C, respectively.

Referring to FIG. 6, an electronic device 1000 may include at least one processor 1100, a communication module 1200, an input/output module 1300, a storage 1400, and a buffer random access memory (RAM) module 1500. The electronic device 1000 may be a mobile device such as a smartphone or a tablet computer, not being limited thereto, according to embodiments.

The processor 1100 may include a central processing unit (CPU), a graphic processing unit (GPU) and/or any other processors that control operations of the electronic device 1000. The communication module 1200 may be implemented to perform wireless or wire communications with an external device. The input/output module 1300 may include at least one of a touch sensor, a touch panel a key board, a mouse, a proximate sensor, a microphone, etc. to receive an input, and at least one of a display, a speaker, etc. to generate an output signal processed by the processor 1100. The storage 1400 may be implemented to store user data input through the input/output module 1300, the output signal, etc. The storage 1400 may be an embedded multimedia card (eMMC), a solid state drive (SSD), a universal flash storage (UFS) device, etc.

The buffer RAM module 1500 may temporarily store data used for processing operations of the electronic device 1000. For example, the buffer RAM 1500 may include a volatile memory such as double data rate (DDR) synchronous dynamic random access memory (SDRAM), low power double data rate (LPDDR) SDRAM, graphics double data rate (GDDR) SDRAM, Rambus dynamic random access memory (RDRAM), etc.

Although not shown in FIG. 6, the electronic device 1000 may further include at least one sensor such as an image sensor.

At least one component in the electronic device 1000 may be formed based on the 3D-stacked semiconductor device 30 or 40 in which corner rounding is removed or reduced in active regions having different widths across a plurality of cells.

The foregoing is illustrative of example embodiments and is not to be construed as limiting the disclosure. Although a few example embodiments have been described, those skilled in the art will readily appreciate that many modifications are possible in the above embodiments without materially departing from the disclosure.

## Claims

1. A semiconductor device comprising
a 1^{st} active region (110, 120) extended in a 1^{st} direction (D1) and comprising:
a 1^{st} out-corner edge (R11) at which a width of the 1^{st} active region (110, 120) in a 2^{nd} direction (D2) gradually changes along the 1^{st} direction; and
a 1^{st} in-corner edge (R12) at which the width of the 1^{st} active region (110, 120) less gradually changes along the 1^{st} direction (D1) than at the 1^{st} out-corner edge (R11),
wherein the gate structure (153) extends in the 2^{nd} direction (D2) and overlaps the 1^{st} out-corner edge (R11) in a 3^{rd} direction (D3), and
wherein the 1^{st} direction (D1) horizontally intersects the 2^{nd} direction (D2), and the 3^{rd} direction (D3) vertically intersects the 1^{st} direction (D1) and the 2^{nd} direction (D2).

2. The semiconductor device of claim 1, wherein the 1^{st} active region (110, 120) comprises;
a 1^{st} source/drain region (SD11);
a 2^{nd} source/drain region (SD12); and
a 1^{st} channel structure (CH11) between the 1^{st} source/drain region (SD11) and the 2^{nd} source/drain region (SD12), and overlapped by the gate structure (153) in the 3^{rd} direction (D3),
wherein the 1^{st} out-corner edge (R11) overlapped by the gate structure (153) in the 3^{rd} direction (D3) is included in the 1^{st} channel structure (CH13).

3. The semiconductor device of claim 1 or 2, further comprising:
a 2^{nd} active region (210, 220) extended in the 1^{st} direction (D1), above the 1^{st} active region (110, 120), and comprising:
a 2^{nd} out-corner edge (R21) at which a width of the 2^{nd} active region (210, 220) in the 2^{nd} direction (D2) gradually changes along the 1^{st} direction (D1); and
a 2^{nd} in-corner edge (R22) at which the width of the 2^{nd} active region (210, 220) less gradually changes along the 1^{st} direction (D1) than at the 2^{nd} out-corner edge (R21),
wherein the gate structure (153) overlaps the 2^{nd} out-corner edge (R21) in the 3^{rd} direction (D3).

4. The semiconductor device of claim 3, wherein the width of the 1^{st} active region (110, 120) is greater than the width of the 2^{nd} active region (210, 220).

5. The semiconductor device of claim 3 or 4, wherein the 2^{nd} out-corner edge (R21) is aligned with the 1^{st} out-corner edge (R11) in the 2^{nd} direction (D2).

6. The semiconductor device of claim 5, wherein the 2^{nd} in-corner edge (R22) is aligned with the 1^{st} in-corner edge (R12) in the 2^{nd} direction (D2).

7. The semiconductor device of any one of claims 3 to 6, wherein the 1^{st} active region comprises;
a 1^{st} source/drain region (SD11);
a 2^{nd} source/drain region (SD12);
a 1^{st} channel structure (CH11) between the 1^{st} source/drain region (SD11) and the 2^{nd} source/drain region (SD12), and overlapped by the gate structure (153) in the 3^{rd} direction (D3); and
wherein the 2^{nd} active region (210, 220) comprises:
a 3^{rd} source/drain region (SD21) above the 1^{st} source/drain region (SD11) in the 3^{rd} direction (D3);
a 4^{th} source/drain region (SD22) above the 2^{nd} source/drain region (SD12) in the 3^{rd} direction (D3); and
a 2^{nd} channel structure (CH23) between the 3^{rd} source/drain region (SD21) and the 4^{th} source/drain region (SD22), and overlapped by the gate structure (153) in the 3^{rd} direction (D3),
wherein the 1^{st} out-corner edge (R11) is included in the 1^{st} channel structure (CH13), and
wherein the 2^{nd} out-corner edge (R21) is included in the 2^{nd} channel structure (CH23).

8. The semiconductor device of any one of claims 3 to 7, wherein the 2^{nd} active region (210, 220) comprises:
a 3^{rd} region (210) at the 1^{st} side of the 2^{nd} out-corner edge (R21) opposite to the 2^{nd} in-corner edge (R22), the 3^{rd} region (210) having a 3^{rd} width (W2) in the 2^{nd} direction (D2); and
a 4^{th} region (220) at the 2^{nd} side of the 2^{nd} in-corner edge (R22) opposite to the 2^{nd} out-corner edge (R21), the 4^{th} region (220) having a 4^{th} width (W4) in the 2^{nd} direction (D2),
where the 3^{rd} width (W2) is uniform along the 1^{st} direction (D1), and the 4^{th} width (W4) is uniform along the 1^{st} direction (D1), and
wherein the 3^{rd} width (W2) is different from the 4^{th} width (W4).

9. The semiconductor device of claim 8, wherein the 1^{st} region (110) and the 3^{rd} region (210) are included in a 1^{st} cell (C 1) of the semiconductor device, and the 2^{nd} region (120) and the 4^{th} region (220) are included in a 2^{nd} cell (C2) of the semiconductor device.

10. The semiconductor device of any one of claims 1 to 9, wherein the 1^{st} active region (110, 120) comprises:
a 1^{st} region (110) at a 1^{st} side of the 1^{st} out-corner edge (R11) opposite to the 1^{st} in-corner edge (R12), the 1^{st} region (110) having a 1^{st} width (W1) in the 2^{nd} direction (D2); and
a 2^{nd} region (120) at a 2^{nd} side of the 1^{st} in-corner edge (R12) opposite to the 1^{st} out-corner edge (R11), the 2^{nd} region (120) having a 2^{nd} width (W3) in the 2^{nd} direction (D2),
where the 1^{st} width (W3) is uniform along the 1^{st} direction (D1), and the 2^{nd} width (W3) is uniform in the 1^{st} direction (D1), and
wherein the 1^{st} width (W1) is different from the 2^{nd} width (W3).

11. The semiconductor device of claim 10, wherein the 1^{st} region (110) is included in a 1^{st} cell (C1) of the semiconductor device, and the 2^{nd} region (120) is included in a 2^{nd} cell (C2) of the semiconductor device.

12. The semiconductor device of any one of claims 1 to 11, wherein the 1^{st} in-corner edge (R12) is not overlapped by the gate structure (153) in the 3^{rd} direction (D3).

13. A method of manufacturing a semiconductor device, the method comprising:
providing, on a substrate (101), a 1^{st} active region (110, 120) comprising a 1^{st} region (110), a 2^{nd} region (120) and a 1^{st} channel region (CH13) aligned in a 1^{st} direction (D1), wherein the 1^{st} region (110) and the 2^{nd} region (120) have a 1^{st} width and a 2^{nd} width smaller than the 1^{st} width in a 2^{nd} direction (D2), respectively, and the 1^{st} channel region (CH13) has a 1^{st} out-corner edge (R11), where the 1^{st} width is gradually decreased, and a 1^{st} in-corner edge (R12) where the 2^{nd} width is gradually increased;
performing cut-mask patterning on the 1^{st} in-corner edge (R12) such that a curvature of the 1^{st} in-corner edge (R12) is increased;
forming a dummy gate structure on the 1^{st} active region such that the 1^{st} out-corner edge (R11) is overlapped by the dummy gate structure in a 3^{rd} direction (D3); and
forming 1^{st} source/drain regions (SD11) based on the channel region (CH13),
wherein the 1^{st} direction (D1) horizontally intersects the 2^{nd} direction (D2), and the 3^{rd} direction (D3) vertically intersects the 1^{st} direction (D1) and the 2^{nd} direction (D2).

14. The method of claim 13, further comprising replacing the dummy gate structure with a gate structure (153).

15. The method of claim 14, wherein the cut-mask patterning is performed based on a bottom diffusion isolation, BDI, layer formed between the substrate and the 1^{st} active region (110, 120).

## Amended claims

### Amended claims in accordance with Rule 137(2) EPC.

1. A semiconductor device comprising
a 1^{st} active region (110, 120) extended in a 1^{st} direction (D1) and comprising:
a 1^{st} out-corner edge (R11) at which a width of the 1^{st} active region (110, 120) in a 2^{nd} direction (D2) gradually changes along the 1^{st} direction, and
a 1^{st} in-corner edge (R12) at which the width of the 1^{st} active region (110, 120) less gradually changes along the 1^{st} direction (D1) than at the 1^{st} out-corner edge (R11), wherein a curvature of the 1^{st} in-corner edge (R12) is greater than a curvature of the 1^{st} out-corner edge (R11); and
a gate structure (153) extending in the 2^{nd} direction (D2) and overlapping the 1^{st} out-corner edge (R11) in a 3^{rd} direction (D3),
wherein the 1^{st} direction (D1) horizontally intersects the 2^{nd} direction (D2), and the 3^{rd} direction (D3) vertically intersects the 1^{st} direction (D1) and the 2^{nd} direction (D2).

2. The semiconductor device of claim 1, wherein the 1^{st} active region (110, 120) comprises;
a 1^{st} source/drain region (SD11);
a 2^{nd} source/drain region (SD12); and
a 1^{st} channel structure (CH11) between the 1^{st} source/drain region (SD11) and the 2^{nd} source/drain region (SD12), and overlapped by the gate structure (153) in the 3^{rd} direction (D3),
wherein the 1^{st} out-corner edge (R11) overlapped by the gate structure (153) in the 3^{rd} direction (D3) is included in the 1^{st} channel structure (CH13).

3. The semiconductor device of claim 1 or 2, further comprising:
a 2^{nd} active region (210, 220) extended in the 1^{st} direction (D1), above the 1^{st} active region (110, 120), and comprising:
a 2^{nd} out-corner edge (R21) at which a width of the 2^{nd} active region (210, 220) in the 2^{nd} direction (D2) gradually changes along the 1^{st} direction (D1); and
a 2^{nd} in-corner edge (R22) at which the width of the 2^{nd} active region (210, 220) less gradually changes along the 1^{st} direction (D1) than at the 2^{nd} out-corner edge (R21),
wherein the gate structure (153) overlaps the 2^{nd} out-corner edge (R21) in the 3^{rd} direction (D3).

4. The semiconductor device of claim 3, wherein the width of the 1^{st} active region (110, 120) is greater than the width of the 2^{nd} active region (210, 220).

5. The semiconductor device of claim 3 or 4, wherein the 2^{nd} out-corner edge (R21) is aligned with the 1^{st} out-corner edge (R11) in the 2^{nd} direction (D2).

6. The semiconductor device of claim 5, wherein the 2^{nd} in-corner edge (R22) is aligned with the 1^{st} in-corner edge (R12) in the 2^{nd} direction (D2).

7. The semiconductor device of any one of claims 3 to 6, wherein the 1^{st} active region comprises;
a 1^{st} source/drain region (SD11);
a 2^{nd} source/drain region (SD12);
a 1^{st} channel structure (CH11) between the 1^{st} source/drain region (SD11) and the 2^{nd} source/drain region (SD12), and overlapped by the gate structure (153) in the 3^{rd} direction (D3); and
wherein the 2^{nd} active region (210, 220) comprises:
a 3^{rd} source/drain region (SD21) above the 1^{st} source/drain region (SD11) in the 3^{rd} direction (D3);
a 4^{th} source/drain region (SD22) above the 2^{nd} source/drain region (SD12) in the 3^{rd} direction (D3); and
a 2^{nd} channel structure (CH23) between the 3^{rd} source/drain region (SD21) and the 4^{th} source/drain region (SD22), and overlapped by the gate structure (153) in the 3^{rd} direction (D3),
wherein the 1^{st} out-corner edge (R11) is included in the 1^{st} channel structure (CH13), and
wherein the 2^{nd} out-corner edge (R21) is included in the 2^{nd} channel structure (CH23).

8. The semiconductor device of any one of claims 1 to 7, wherein the 1st active region (110, 120) comprises:
a 1^{st} region (110) at a 1st side of the 1st out-corner edge (R11) opposite to the 1^{st} in-corner edge (R12), the 1^{st} region (110) having a 1^{st} width (W1) in the 2^{nd} direction (D2); and
a 2^{nd} region (120) at a 2^{nd} side of the 1st in-corner edge (R12) opposite to the 1^{st} out-corner edge (R11), the 2^{nd} region (120) having a 2^{nd} width (W3) in the 2^{nd} direction (D2),
where the 1^{st} width (W3) is uniform along the 1st direction (D1), and the 2^{nd} width (W3) is uniform in the 1^{st} direction (D1), and
wherein the 1^{st} width (W1) is different from the 2^{nd} width (W3).

9. The semiconductor device of claim 8, wherein the 2^{nd} active region (210, 220) comprises:
a 3^{rd} region (210) at the 1^{st} side of the 2^{nd} out-corner edge (R21) opposite to the 2^{nd} in-corner edge (R22), the 3^{rd} region (210) having a 3^{rd} width (W2) in the 2^{nd} direction (D2); and
a 4^{th} region (220) at the 2^{nd} side of the 2^{nd} in-corner edge (R22) opposite to the 2^{nd} out-corner edge (R21), the 4^{th} region (220) having a 4^{th} width (W4) in the 2^{nd} direction (D2),
where the 3^{rd} width (W2) is uniform along the 1^{st} direction (D1), and the 4^{th} width (W4) is uniform along the 1^{st} direction (D1), and
wherein the 3^{rd} width (W2) is different from the 4^{th} width (W4).

10. The semiconductor device of claim 9, wherein the 1^{st} region (110) and the 3^{rd} region (210) are included in a 1^{st} cell (C1) of the semiconductor device, and the 2^{nd} region (120) and the 4^{th} region (220) are included in a 2^{nd} cell (C2) of the semiconductor device.

11. The semiconductor device of any one of claims 8 to 10, wherein the 1^{st} region (110) is included in a 1^{st} cell (C1) of the semiconductor device, and the 2^{nd} region (120) is included in a 2^{nd} cell (C2) of the semiconductor device.

12. The semiconductor device of any one of claims 1 to 11, wherein the 1^{st} in-corner edge (R12) is not overlapped by the gate structure (153) in the 3^{rd} direction (D3).

13. A method of manufacturing a semiconductor device, the method comprising:
providing, on a substrate (101), a 1^{st} active region (110, 120) comprising a 1^{st} region (110), a 2^{nd} region (120) and a 1^{st} channel region (CH13) aligned in a 1^{st} direction (D1), wherein the 1^{st} region (110) and the 2^{nd} region (120) have a 1^{st} width and a 2^{nd} width smaller than the 1^{st} width in a 2^{nd} direction (D2), respectively, and the 1^{st} channel region (CH13) has a 1^{st} out-corner edge (R11), where the 1^{st} width is gradually decreased, and a 1^{st} in-corner edge (R12) where the 2^{nd} width is gradually increased;
performing cut-mask patterning on the 1^{st} in-corner edge (R12) such that a curvature of the 1^{st} in-corner edge (R12) is increased, and a curvature of the 1^{st} in-corner edge (R12) is greater than a curvature of the 1^{st} out-corner edge (R11);
forming a dummy gate structure on the 1^{st} active region such that the 1^{st} out-corner edge (R11) is overlapped by the dummy gate structure in a 3^{rd} direction (D3); and
forming 1^{st} source/drain regions (SD11) based on the channel region (CH13),
wherein the 1^{st} direction (D1) horizontally intersects the 2^{nd} direction (D2), and the 3^{rd} direction (D3) vertically intersects the 1^{st} direction (D1) and the 2^{nd} direction (D2).

14. The method of claim 13, further comprising replacing the dummy gate structure with a gate structure (153).

15. The method of claim 14, wherein the cut-mask patterning is performed based on a bottom diffusion isolation, BDI, layer as etch stop layer formed between the substrate and the 1^{st} active region (110, 120).
